# EUROPÄISCHE PATENTSCHRIFT

(11) **EP 2 653 583 B1**
(45) Veröffentlichungstag und Bekanntmachung des Hinweises auf die Patenterteilung: **10.03.2021**
(21) Anmeldenummer: 13161346.5
(22) Anmeldetag: 27.03.2013
(51) Int. Cl.: C23C 14/00, C23C 14/06, C23C 14/32, C23C 14/34, C23C 14/35

(54) **Beschichtungsverfahren zur Abscheidung eines Schichtsystems auf einem Substrat**
Coating method for depositing a coating system on a substrate
Procédé de revêtement destiné à la séparation d'un système de couche sur un substrat

(30) Priorität: 20.04.2012 EP 12164959
(43) Veröffentlichungstag der Anmeldung: 23.10.2013
(73) Patentinhaber: Oerlikon Surface Solutions AG, Pfäffikon, 8808 Pfäffikon SZ (CH)
(72) Erfinder: VETTER, Jörg, 51469 Bergisch Gladbach (DE); ERKENS, Georg, 52070 Aachen (DE); MÜLLER, Jürgen, 57462 Olpe (DE)
(74) Vertreter: Intellectual Property Services GmbH

(56) Entgegenhaltungen:
- EP-A1- 1 783 245
- EP-A2- 2 037 000
- WO-A1-91/00374
- WO-A1-02/070776
- WO-A1-2009/052874
- DE-A1-102008 021 912
- DE-A1-102010 028 558

## Beschreibung

Die Erfindung betrifft ein Beschichtungsverfahren zur Abscheidung eines Schichtsystems aus Hartstoffschichten auf einem Substrat gemäss Anspruch 1.

Aus dem Stand der Technik bekannte PVD-Schichten, die mit kathodischen Vakuum-Bogenverdampfungstechniken (abgekürzt KVBV) abgeschieden werden, zeigen in zahlreichen Anwendungen im Bereich Verschleißschutz ein ausgezeichnetes tribologisches Verhalten. Es werden heutzutage beispielsweise verschiedenste Werkzeuge (Zerspanung, Umformung, Urformen, Kunststoff) sowie Maschinenbauteile (Spannzangen u.a.) als auch Motorenteile (Kolbenringe, Ventile u.a.) mittels nitridischer, karbidischer und oxidischer Schichten und deren Mischungen beschichtet. Die bekannten PVD Verfahren zeichnen sich durch eine hohe Beschichtungsrate, dichte Schichtstrukturen bedingt durch die hohe Ionisation des verdampften Materials sowie Prozessstabilität aus. Auf der anderen Seite haben die bekannten kathodischen Vakuum-Bogenverdampfungstechniken (KVBV) aber auch eine Reihe von Nachteile.

Ein wesentlicher Nachteil ist die in der Praxis unvermeidliche Dropletemission, d.h. die Emission von kleinen Metallspritzern im nm bis µm Bereich, die sich in ausgewählten Anwendungen in den erzeugten Schichten negativ auswirken können bzw. ein Oberflächenfinish nach der Beschichtung zur Einstellung hinreichend niedriger Rauheitswerte unumgänglich machen. Ein anderer wesentlicher Nachteil besteht darin, dass nicht alle Kathodenmaterialien durch die kathodische Vakuum-Bogenverdampfung (KVBV) industriell verdampft werden können, dies sind z.B. Materialien wie Si, B, SiC, B₄C und andere dem Fachmann an sich bekannte Materialien.

Das klassische DC-Magnetronsputtern weist dabei diese beiden oben genannten Nachteile im wesentlichen nicht auf, wenn es mit typischen zeitlich integrierten Leistungsdichten bis zu 20W/cm² auf dem Target betrieben wird, wobei Stromdichten auf dem Target typischerweise unterhalb von 0,1 A/cm² liegen.

Hinsichtlich der Schichtrauheit ist dabei anzumerken, dass in einzelnen Fällen, insbesondere bei dicken Verschleißschutzschichten, z.B. einige µm dick sind und unter industriellen Bedingungen hergestellt werden, häufig noch eine Nachglättung durch mechanische Bearbeitungsverfahren wie Bürsten, Strahlen, Polieren und andere durchgeführt wird, um störende wachstumsbedingte Rauheitsspitzen zu beseitigen.

Hinsichtlich der einsetzbaren Materialen besteht beim klassischen DC-Magnetronsputtern eine größere Vielfalt als beim Verfahren der KVBV zur Verfügung. So lassen sich neben Metallen und deren Legierungen auch weniger leitfähige Materialien sowie spröde Materialien wie Si; B, SiC, B₄C; MoS₂, WS₂ und anderen sputtern. Dadurch sind die Möglichkeiten der Darstellbarkeit von Schichtzusammensetzungen deutlich vielfältiger als bei der KVBV.

Jedoch auch das klassische DC-Magnetronsputtern hat gewisse Nachteile. So ist das klassische DC-Magnetronsputtern durch eine im Vergleich zur kathodischen Vakuum-Bogenverdampfung niedrigere Beschichtungsrate in industriellen Anlagen charakterisiert, was natürlich gleich in verschiedener Hinsicht ein ökonomischer Nachteil ist. Ausserdem sind die beim klassischen DC-Magnetronsputtern erzeugten Schichten häufig durch ein ausgeprägtes kolumnares Wachstum, bedingt durch die verhältnismässig niedrige Ionisation des abgesputterten Materials gekennzeichnet, was leider häufig in vielen Anwendungen zu einem Nachteil der Funktionalität der Schichten führt.

Daher wurde das klassische DC-Magnetronsputtern in den vergangenen Jahren und Jahrzehnten ständig weiterentwickelt und verbessert. Wesentliche Fortschritte sind dabei durch einen Betrieb der Magnetrons im gepulsten Mode mit hohen Strömen bzw. Stromdichten erzielt worden, was zu einer verbesserten Schichtstruktur in Form von dichteren Schichten, insbesondere Aufgrund einer verbesserten Ionisation des abgesputterten Materials führt. Dadurch wird das kolumnare Wachstum in einem vorgebbaren Umfang unterdrückt bzw. kann sogar gänzlich verhindert werden. Dieses Verfahren des Magnetronsputterns im gepulsten Mode mit hohen Strömen bzw. Stromdichten wird häufig auch "High lonized Impuls Magnetron Sputtering" oder abgekürzt HIPIMS genannt. Die Stromdichten am Target übersteigen beim HIPIMS typischerweise die des klassichen DC-Magnetronsputterns, d.h. sie liegen oberhalb von 0.1 A/cm² bis zu einigenA/cm², so dass Leistungsdichten von einigen 100 W/cm² bis hin zum MW/cm² am Target kurzzeitig angelegt werden.

Die Prozessbedingungen zur Abscheidung von Schichten beim Magnetronsputtern und bei der kathodischen Vakuum-Bogenverdampfung (KVBV) sind typischerweise unterschiedlich.

Als Sputtergas beim Magnetronsputtern wird meist Ar eingesetzt. Zur reaktiven Abscheidung von nitridischen, karbischen, oxidischen Schichten und deren Mischungen wird das entsprechende Reaktivgas zugegeben. Oft wird in der Praxis mit einem Gasfluss des Argons gearbeitet, der größer als der Fluss des Reaktivgases zur Schichtabscheidung ist. Der Beschichtungsdruck liegt meist im Bereich von 0.1 bis 1 Pa.

Bei der KVBV wird meist ohne Ar gearbeitet, d.h. mit 100 % tigen Reaktivgas. Für die Abscheidung von nitridischen Schichten kommt oft reiner Stickstoff zum Einsatz. Die reaktive Abscheidung der Schichten wird häufig im Druckbereich von 0.05 bis 1 Pa durchgeführt. Beim Einsatz vom pulvermetallurgischen Kathoden mit hohem Al-Anteil haben sich dabei höhere Drücke bewährt. Typischerweise kommen dann Reaktivgasdrücke im Bereich von 2 bis 10 Pa zum Einsatz. Entsprechend ist von einer Konfliktsituation der Kompatibilität hinsichtlich der Druckbereiche und verwendeten Gase auszugehen. Typische Beschichtungsverfahren sind aus EP1783245, WO2009052874 und DE102010028558 bekannt.

Die Aufgabe der Erfindung ist es daher ein verbessertes Beschichtungsverfahren zur Herstellung eines Mehrschichtsystems und daraus resultierend ein Substrat mit einem verbesserten Schichtsystem bereitzustellen, das die aus dem Stand der Technik bekannten Nachteile vermeidet.

Die diese Aufgaben lösenden Gegenstände der Erfindung sind durch die Merkmale des unabhängigen Anspruchs 1 gekennzeichnet.

Die abhängigen Ansprüche beziehen sich auf besonders vorteilhafte Ausführungsformen der Erfindung.

Die Erfindung betrifft somit ein Beschichtungsverfahren zur Abscheidung eines Schichtsystems gebildet aus Hartstoffschichten auf einem Substrat, gemäss Anspruch 1.

Somit ist es überraschenderweise durch die vorliegende Erfindung gelungen, neuartige multilagige Schichtsysteme zu generieren, die die Vorteile beider Beschichtungsmethoden, nämlich der kathodischen Vakuum-Bogenverdampfung (KVBV) und dem Magnetronentladungsverfahren im HIPIMS-Modus in sich zu vereinen.

Im Folgenden wird die Erfindung anhand der schematischen Zeichnung und weiteren sehr speziellen Ausführungsbeispielen noch näher im Detail erläutert. Es zeigen:

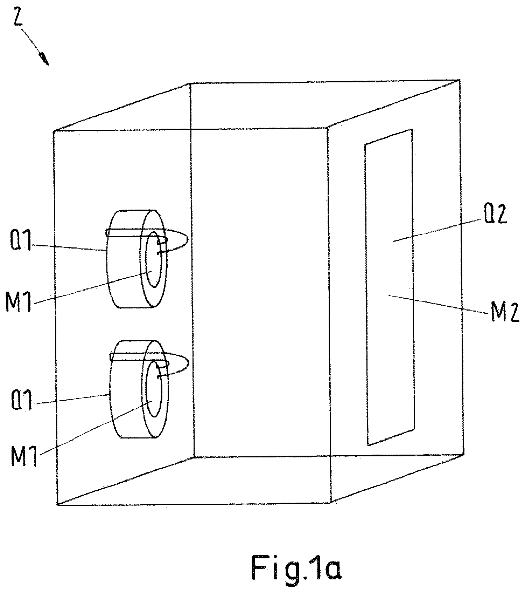

- Fig. 1a: in schematischer Darstellung eine Prozesskammer mit einer kathodischen Vakuum-Bogenverdampfungsquelle (KVBV-Quelle)) und einer Magnetronentladungsquelle, die im HIPMS-Modus (HIPIMS-Sputterquelle) betreibbar ist, diese Konfiguration ist ein Beispiel vom Stand der Technik bekannten Konfiguration;

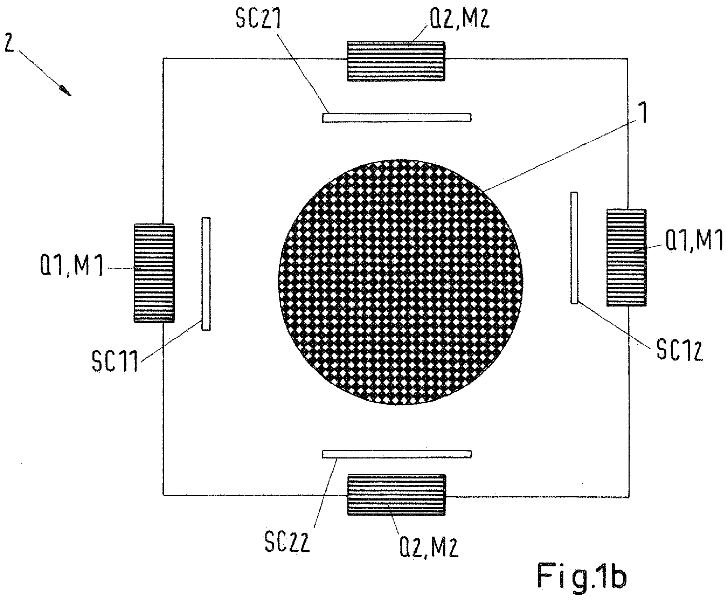

- Fig. 1b: Prozesskammer mit mehreren Verdampfungs- und Entladungsquellen;

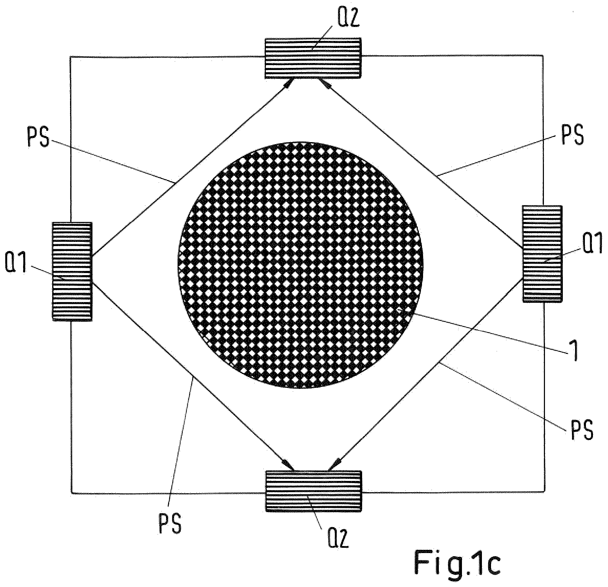

- Fig. 1c: eine Prozesskammer mit mehreren Verdampfungs- und Entladungsquellen ohne Shutter;
- Fig. 1 d: Prozesskammer mit mehreren Verdampfungs- und Entladungsquellen mit geöffneten Shuttern;
- Fig. 2: schematisch ein erfindungsgemässes Substrat mit einem dreilagigen Schichtsystem;
- Fig. 3a: closed-field unbalanced Magnetron HIPIMS Anordnung;

In einem besonders einfachen Ausführungsbeispiel ist eine apparative Basis zur Durchführung eines Verfahrens beispielweise durch eine Anlagenkonfiguration gemäss Fig. 1a gegeben, die in stark schematischer Darstellung eine Prozesskammer 2 mit einer kathodischen Vakuum-Bogenverdampfungsquelle Q1, die abgekürzt auch als KVBV-Quelle Q1 bezeichnet wird und einer Magnetronentladungsquelle Q2, die bei einem erfindungsgemässen Verfahren im HIPMS-Modus betrieben wird, und abgekürzt auch HIPIMS-Sputterquelle Q2, oder kürzer auch als HIPIMS-Quelle Q2 bezeichnet wird.

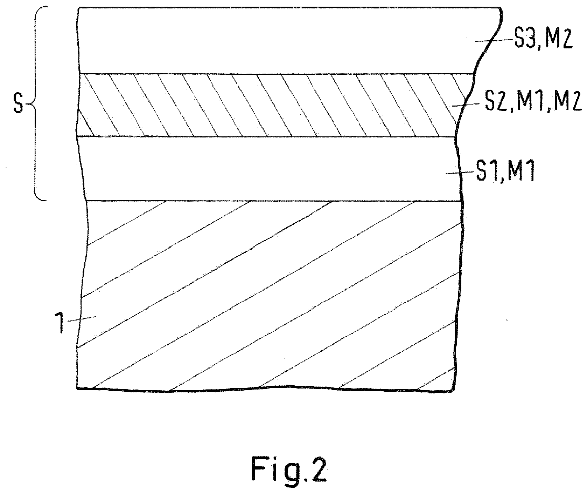

Im Folgenden soll zunächst die Herstellung eines erfindungsgemässen mehrlagigen Schichtsystems S auf einem Substrat 1, wie es schemtaisch z.B. in Fig. 2 dargestellt ist, an einem einfachen Ausführungsbeispiel diskutiert werden. Das Erfindungegemässe Schichtsystem gemäss Fig. 2 soll dabei möglichst wenige Wachstumsstörungen aufweisen, wobei gleichzeitig eine dichte Schichtstruktur angestrebt wird. Das erfindungsgemässe Schichtsystem S gem. Fig. 2 besteht aus einer Kontaktschicht S1, die mittels eines ersten zu atomisierenden Verdampfungsmaterials M1, das mit mindestens einer ersten Quelle Q1 gem. Fig. 1a atomisiert und auf das Substrat 1 aufgebracht wird. Einer auf der Kontaktschicht S1 befindlichen nanostrukturierten Zwischenschicht S2 bestehend aus dem Verdampfungsmaterial M1 und einem weiteren Entladungsmaterial M2, wobei das zu atomisierenden Entladungsmaterial M2 durch zwei Magnetronentladungsquelle Q2 bereitgestellt wird, sowie einer Deckschicht S3, die das Material M2 enthält. Zur Einstellung von nitridischen, karbidischen, oder oxidischen Anteilen wie AlTiXN, AlCrXN, CrON (sowie deren Mischungen) in den Schichten werden während der Abscheidung in den jeweiligen Schichten S1 bis S3 in an sich bekannte Weise entsprechende Reaktivgase in der Prozesskammer 2 eingesetzt.

Zur Beschichtung des Substrats 1 gem. Fig. 2 sind in der Prozesskammer 2 zwei kathodische Vakuumbogenverdampfungsquellen Q1 (KVBV-Quelle) und zwei Magnetronentladungsquelle Q2 installiert, die im HIPIMS-Mode betrieben werden kann (HIPIMS-Quelle).

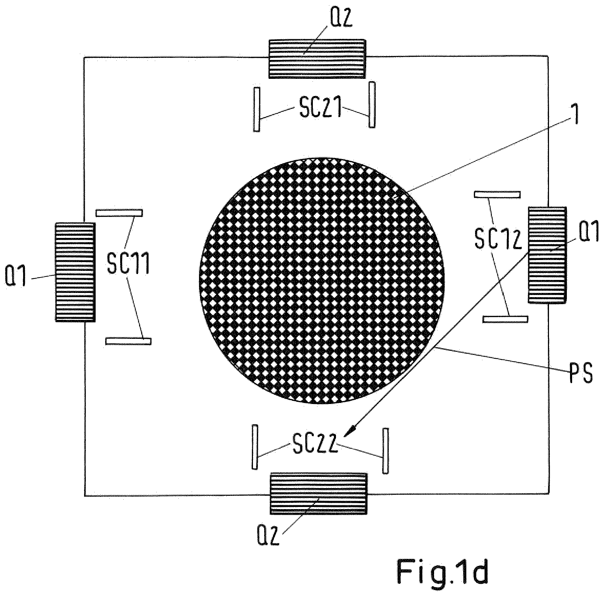

Dabei sind auch komplexere Anordnungen von Beschichtungsquellen in der Prozesskammer 2 möglich, wie zum Beispiel in Fig. 1b, Fig. 1c, Fig. 1d und Fig. 1e schematisch skizziert.

Fig. 1b zeigt beispielweise ein Schnittbild einer Prozesskammer 2 zur Verwendung in einer weiteren speziellen Betriebsweise zur Herstellung erfindungsgemässer Schichten. In der Prozesskammer 2 gem. Fig. 1b sind zwei Magnetronentladungsquellen Q2 mit Entladungsmaterial M2 an zwei gegenüberliegenden Flanschen installiert. Mehrere kathodische VakuumBogenverdampfungsquellen Q1 mit Verdampfungsmaterial M1 befinden sich auf gegenüberliegenden Flanschen, um 90° gegenüber den Magnetronentladungsquellen Q2 versetzt. Dabei werden bevorzugt zwei in Bezug auf die Kammerhöhe übereinander angeordnete Paare von Vakuum-Bogenverdampfungsquellen Q1 verwendet, von denen im Schnittbild der Fig. 1b nur ein Paar zu sehen. Im Beispiel der Fig. 1b nach der Erfindung werden die die Magnetronentladungsquellen Q2 im bipolaren HIPIMS-Mode betrieben. Vor den Quellen befindet sich bevozugt jeweils ein Shutter SC11, SC12, SC21, und SC22, die geschlossen oder geöffnet werden können.

Im folgenden wir beispielhaft ein erstes Schichtsystem beschrieben, das bisher nur unzureichend mit dem Verfahren der kathodischen Vakuum-Bogenverdampfung qualitativ dargestellt werden konnte.

AlTiN-Schichten bewähren sich in einer Vielzahl von Anwendungen wie z.B in der Zerspanung und Umformung. Gerade mittels der kathodischen Vakuum-Bogenverdampfung abgeschiedene Schichten weisen dabei eine hohe Haftfestigkeit auf. Vanadium basierte Schichten weisen dagegen einen speziellen Vorteil auf, wenn Einsatztemperaturen um 600 °C und höher zu Oxidbildungen führen, die ausgezeichnete Reibeigenschaften aufweisen.

Diese Kombination kann zum Design von Schichten dienen, das Schichtfolgen sowohl mit ausgezeichneten Reibeigenschaften als auch Verschleißeigenschaften bei entsprechenden Einsatztemperaturen ermöglicht.

Dazu wurden in einer Prozesskammer 2 kathodische Vakuumverdampfungsquellen Q1 und zwei Magnetronquellen Q2 im HIPIMS-Mode installiert, wie beispielweise schematisch in Fig. 1b dargestellt.

Gemäss Anspruch 1 in der erfindungsgemässen speziellen Betriebsweise wurden die Magnetronentladungsquellen Q2 im bipolaren HIPIMS-Mode betrieben, wie es schematisch in Fig. 1b gezeigt ist. Dabei wurde eine Schichtfolge gemäss Fig. 2 mit Kontaktschicht S1 aus Verdampfungsmaterial M1, einer Zwischenschicht S2 aus Verdampfungsmaterial M1 und Entladungsmaterial M2, und einer Deckschicht S3 aus Entladungsmaterial M2 abgeschieden. Überraschender weise stellte sich eine Rauheit ein, die niedriger wahr als die der reinen Kontaktschichten S1 ohne Zwischenschicht S2 und / oder Deckschicht S3.

Weitere Versuchsergebnisse und die Vorgehensweise bei der Abscheidung erfindungsgemässer Schichtsysteme sollen nachfolgend etwas detaillierter erläutert werden.

Im speziellen wurde ein Schichtsystem S gemäss Fig. 2 mit einer AITiN Kontaktschicht S1 aus AITi als Verdampfungsmaterial M1 und einem stickstoffhaltigen Prozessgas hergestellt. Auf die AITiN Kontaktschicht wurde eine AlTiN-VZrN Zwischenschicht in Form einer nanostrukturierten Mischschicht aufgebracht. D.h., die Zwischenschicht wurde aus AITi als Verdampfungsmaterial M1 und aus VZr als Entladungsmaterial M2 und dem stickstoffhaltigen Prozessgas hergestellt. Schliesslich wurde auf die Zwischenschicht eine VZrN Deckschicht aus dem Entladungsmaterial M2 bestehend aus VZr und dem stickstoffhaltigen Prozessgas gebildet und abgeschieden. Zum Vergleich wurden reine AlTiNSchichten sowie zwei multilagige Schichtsysteme mittels kathodischer Vakuum-Bogenverdampfung allein abgeschieden. Die Versuchergebnisse nebst wichtiger Schicht und Verfahrensparameter sowie die erzielte Rauheit der verschiedenen Schichten sind in Tabelle 1 zusammengestellt. Die angetrebte Schichtdicke war ca. 4 µm, wobei die Schwankungen der Schichtdicken zwischen den einzelnen Prozessen und innerhalb eines Schichtsystems bei ca. +/- 10% der Schichtdicke lagen.

### Zur Herstellung der AITiN Schichten:

Zunächst wurden nach an sich bekannter Vorbehandlung des Substrats (z.B. Heizen auf 500°C und Ar-Ionenreinigung mittels des AEGD-Verfahrens) eine AlTiN-Schicht im reinen Stickstoff bei 6Pa Reaktivgasdruck und einem Verdampferstrom von 150 A auf polierten Proben abgeschieden. Die Vorspannung an den Proben betrug während der Beschichtung 50V. Es wurde eine typische Rauheit Ra von ca. 0,21 µm erzielt.

### Nur kathodisches Vakuumverdampfungsverfahren, AITiN mit Toplage VZrN:

Derartige Schichten wurden in der Kombination AITiN für die Kontaktschicht mittels KVBV und VZrN der Deckschicht ebenfalls mittels der KVBV abgeschieden. Widerum kam ein Verdampferstrom von 150 A und ein Druck von 6 Pa für AITiN zum Einsatz, für VZrN wurde ein Druck von 3Pa verwendet, nach entsprechender Vorbehandlung zum Einsatz. Dies führte zu einer deutlichen Erhöhung der Rauheit. Grund dafür ist die hohe Dropletemission der VZr-kathoden. Es entstand eine Rauheit Ra von 0,42 µm.

### Nur kathodisches Vakuumverdampfungsverfahren für Kontaktschicht AITiN und Parallelbetrieb AlTiN/VZrN und Deckschicht VZrN:

Nach gleicher Vorbehandlung und bei gleichen Prozessparametern wurde nun zwischen der Kontaktschicht und der Deckschicht eine nanostrukturierte Zwischenschicht durch das parallele Betreiben von AITi und VZr kathodischen Vakuumbogenverdampfern abgeschieden. Dies führte zu einer weiteren Erhöhung der Rauheit auf Ra 0,55 µm. Dies ist vermutlich durch die längere Laufzeit der des Verdampfens der VZr-Kathoden mittels der KVBV bedingt.

Ein erfindungsgemässes Schichtsystem S. KVBV für AITiN Kontaktschicht S1, KVBV von AITiN im Parallelbetrieb mit Magnetronentladung im HIPIMS-Modus von VZrN für die Zwischenschicht S2 und die VZrN Deckschicht S3 mit Magnetronentladung im HIPIMS-Modus:
Die Schicht S1 wurden mittels der KVBV abgeschieden. Im nächsten Schritt wurde die nanostrukturierte Schicht S2 durch die Kombination der KVBV und des HIPIMS zwischen S1 und S3 erzeugt. Überraschenderweise war der Prozess stabil, obgleich bei Drücken von mehreren Pa gearbeitet wurden ist, der untypisch für Sputterprozesse ist. Zugleich wurde ein Sputtern des VZr vom Target festgestellt, obgleich das dominierende Gas Stickstoff war. Es ist zu vermuten, dass durch die Anregung der Stickstoffmoleküle bzw. deren Atomisierung oder gar Ionisation der Stickstoffatome, die durch das gleichzeitige Betreiben der KVBV extrem hoch ist, der Sputterprozess unterstützt wird. Des Weiteren könnten bei den hohen Vorspannungen am Sputtertarget (bis zu 1000 V) auch Metallionen (Al oder Ti), die durch die KVBV erzeugt werden zum Sputterprozess beitragen. Es stellte sich unerwarte eine sehr niedrige Rauheitein von Ra = 0,13 µm, die niedriger als die der reinen S1 Schicht ist.

Wie Tabelle 1 eindeutig zu entnehmen ist, lässt sich mit dem erfindungsgemässen Beschichtungsverfahren ein Schichtsystem mit der Schichtfolge S1, S2, S3 herstellen, dass eine deutlich niedrigere Rauheit hat, als Schichten von im Prinzip gleicher chemischer Zusammensetzung, die mit einem aus dem Stand der Technik bekannten Verfahren hergestellt wurden.

**Tabelle 1: Vergleich Beispiele 1 bis 3 aus dem Stand der Technik mit einer Schicht Beispiel 4 gemäss der Erfindung**

| **Beispiel** | **Schicht S1** | **Schicht S2** | **Schicht S3** | **Rauheit Ra in µm** | **Druck S1+S2** | **Druck S3** | **Gas S1** | **Gas S2** | **Gas S3** |
|---|---|---|---|---|---|---|---|---|---|
| 1 | AlTiN/KVBV 4 µm | keine | keine | 0,21 | 6 Pa | - | 100% N2 | 100%N2 | 100%N2 |
| 2 | AlTiN/KVBV 3 µm | keine | VZrN/KVBV 1 µm | 0,42 | 6 Pa | 3 Pa | 100% N2 | 100%N2 | 100%N2 |
| 3 | AlTiN/KVBV 1,5 µm | AlTi/KVBV VZrN/KVBV 1,5 µm | VZrN/KVBV 1 µm | 0,55 | 6 Pa | 3 Pa | 100%N2 | 100%N2 | 100%N2 |
| 4 | AlTiN/KVBV 1,5 µm | AlTiN/KVBV VZrN/HIPIMS 1,5 µm | VZrN/HIPIM S 1 µm | 0,13 | 6 Pa | 0,8 Pa | 100%N2 | 90% N2 10% Ar | 50%Ar/50%N2 |

Im Folgenden soll exemplarisch ein Ausführungsbeispiel eines erfindungsgemässen Beschichtungsverfahrens im Detail am Schichtbeispiel AlTiN/VZrN beschrieben werden.

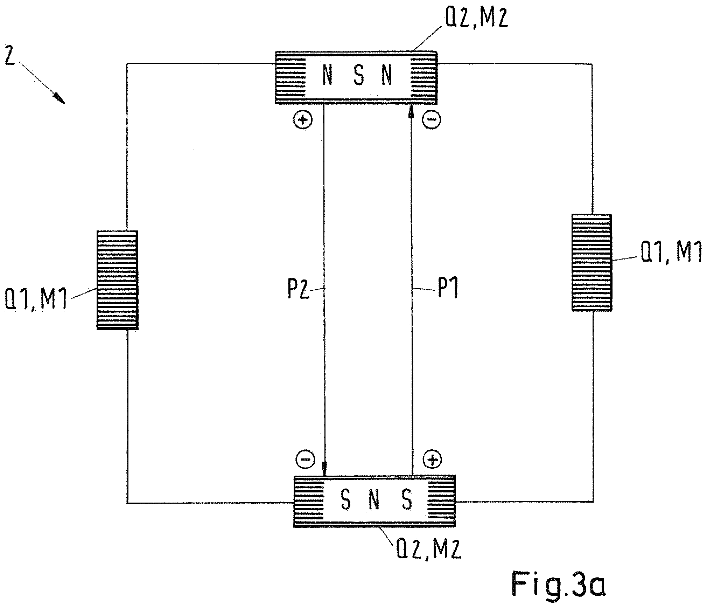

Die Magnetronentladungsquellen werden gemäss Fig. 3a in einem bipolaren Modus betrieben. Wobei im Ausführungsbeispiel der Fig. 3a die Magnetronentladungsquellen Q2 als an sich bekanntes unbalanced Magnetron (UBM-Magnetron) in closed-field Anordnung betrieben werden.

Dabei werden die zwei gegenüberliegende Magnetronentladungsquellen Q2 im HIPIMS-Modus in folgender Weise betrieben: bei einem ersten Puls P1 wird die darstellungsgemäss obere Magnetronentladungsquelle gesputtert, wobei die darstellungsgemäss untere Magnetronentladungsquelle Q2 beim ersten Puls P1 als Anode geschaltes ist. Beim nachfolgenden zweiten Puls P2 wird die darstellungsgemäss untere Magnetronentladungsquelle Q2 gesputtert, wobei die darstellungsgemäss obere Magnetronentladungsquelle Q2 beim zweiten Puls P2 als Anode geschaltes ist.

Die kathodischen Vakuum-Bogenverdampfungsquellen Q1 bestehen hier zu je 50at% Al und 50at%Ti, wobei ein paar von 2 Flanschen mit je drei Verdampfern übereinander aktiv angeordnet sind.

Die in den beiden gegenüberliegenden Magnetronentladungsquellen Q2 eingesetzten Targets für die Hochstrompulsung (HIPIMS) bestehen aus V mit 98,5at% und Zr mit 1,5at%, wobei at% im Rahmen dieser Anmeldung jeweils Atomprozent bedeutet.

Die in Fig. 3a aus Gründen der Übersichtlichkeit nicht dargestellten zu beschichteten Proben wurden vor den Beschichtungsquellen in an sich bekannter Weise dreifach rotiert.

Die Beschichtung der Proben wurde dabei erfindungsgemäss wie folgt durchgeführt:
1. Heizen der Substrate mit Strahlungsheizern auf ca. 500 °C.
2. Ionenreinigung der Substrate mit Ar-Ionen im AEGD Verfahren bei 200 V Vorspannung an den Substraten.
3. Abscheidung der Kontaktschicht S1 mit kathodischem Vakuum-Bogenverdampfung bei z.B. 150 A, 100 % Reaktivgas Stickstoff Fluß ca. 1000 sccm mit 6 Pa, 50V, bis zu einer Schichtdicke von von. ca. 900 nm.
4. Zugabe von Ar zum Gasgemisch, z.B. 900 sccm N2 und 100 sccm Ar.
5. Zünden der beiden VZr Targets (Breite 70 mm, Länge 700 mm) der Magnetronentladungsquellen Q2 hinter einem Shutter (in Fig. 3a nicht dargestellt) im bipolaren Pulsmode. Pulsparameter: Pulslänge 200 µs on, Pulspause 800 µs off. Leistung von 1 bis 10 KW hochgerampt. Die maximale Stromdichte am Target betrug ca. 0,4 A/cm². Schichtdicke ca. 0.9 µm.
7. Abschalten der kathodischem Vakuum-Bogenverdampfungsquellen Q1 und Abscheidung der VZrN-Schicht bei einem Druck von 0.8 Pa, 100 sccm Ar, 100 sccm N2 bei einer Vorspannung von 50 V und Pulsparameter von Pulslänge 150 µs on und Pulspause 1000 µs off resultierend zu einer maximalen Stromdichte von 0,75 A/cm2 auf dem Target mit einer Schichtdicke von 330 nm.

Die Schichtwachstumsrate in der Kontaktschicht S1 und der Zwischenschicht S2 waren mit ca. 2300 nm/h nahezu gleich. Die Schichtwachstumsrate der Deckschicht S3 betrug ca. 170 nm/h.

Mittels EDX-Messungen wurden V Gehalte von unterhalb 5 at% in der Zwischenschicht S2 gemessen, die ansonsten aus den elementen Al, Ti und N besteht. Es ist davon auszugehen, dass Zr bedingt durch die geringe Konzentration im Target sehr schwer nachweisbar ist. Diese geringen Mengen an durch die Magnetronentladungsquellen Q2 eingebrachten Elemente sind Folge des Verhältnisses der Schichtwachstumsrate zwischen kathodischem Vakuum-Bogenverdampfungsquellen Q1 und der HIPIMS-Magnetrons der Magnetronentladungsquellen Q2, das bei ca. 1:14 lag. Daneben ist es möglich, dass die Sputterrate bei der Zwischenschicht S2 zusätzlich niedriger ausfällt als bei der Deckschicht S3.

Die REM Bruchstruktur eines erfindungsgemäss hergestellten Schichtsystems S zeigt, dass die Kontaktschicht S1 kolumnar aufwächst. Die sich anschließende Zwischenschicht S2 weist eine nahezu gleiche kolumnare Struktur auf. Auch die durch HIPMS abgeschiedene Deckschicht S3 weist eine extrem dichte feinkolumnare Schicht auf. Das kolumnare Wachstum wird also in allen Schichten S1, S2 und S3 des Schichtsystems S beibehalten. Eine weitere in der Praxis wichtige Klasse von Schichtsystemen sind extrem oxidationsbeständige Schichten des Typs SiBNC. Diese Schichten wachsen amorph auf und dienen als Topschicht zum Oxidationsschutz. Weiterhin ist bekannt, dass das Einbringen von Legierungselementen wie Si und B in AlTiN-Basisschichten deren Oxidationsbeständigkeit erhöhen. Aus diesem Grunde wurde hier auch die Vorgehensweise der Schichtfolge S1, S2, S3 gewählt. Die Herstellung einer derartigen Schicht unter Verwendung eines unipolaren Modus mit Target wird nun nachfolgend genauer beschrieben.

Die kathodischen Vakuum-Bogenverdampfungsquellen Q2 wurden mit Targets bestückt, die: je 55at% Al und 45at%Ti, an zwie Flanschen mit je drei Verdampfern übereinander aktiv.

Die Magnetronentladunsgquellen Q2 (HIPIMS) wurden mit einer Mischung keramischer Bestandteile und Bindeanteile mit folgender resultierender Zusammensetzung 66 at% Si, 20 at% B, und 14 at% C bestückt.

Die Proben wurden beim Beschichten in doppelter Rotation vor den Quellen platziert.

Die Beschichtung der Proben wurde dabei erfindungsgemäss wie folgt durchgeführt:
1. Heizen der Substrate mit Strahlungsheizern auf ca. 500 °C.
2. Ionenreinigung der Substrate mit Ar-Ionen im AEGD Verfahren bei 200 V Vorspannung an den Substraten.
3. Abscheidung der ersten Schicht mit kathodischem Vakuum Bogenverdampfung z.B. 150 A, Reaktivgas Stickstoff (1000 Sccm) mit 5Pa, 50V, bis zu einer Schichtdicke von 2 µm.
4. Zugabe von Ar zum Gasgemisch bei konstantem Druck, 850 sccm N2, 75 sccm Ar.
5. Zünden eines SiBC Targets hinter einem Shutter. Pulsparameter Pulslänge 50µs on, Pulspause 950µs off. Leistung von 1 bis 2.5 kW hochgerampt. Die resultierende Stromdichte am Target betrug ca. 0,2 A/cm².
6. Abscheidung der nanolagigen Kompositschicht bis zur einer Schichtdicke von 4 µm.
7. Abschalten der kathodischen Vakuum Bogenverdampfung und Abscheidung der SiBNC-Schicht bei einem Druck von 0.8 Pa, 100 sccm Ar, 100 sccm N2 bei einer Vorspannung von 50 V und Pulsparameter von Pulslänge 100 µs on und Pulspause 900 µs off bei einer Leistung von 5 KW resultierende maximale Stromdichte von 0,4 A/cm2 auf dem Target, bis zu einer Schichtdicke von 4,3 µm. Die Schichtwachstumsrate in der Kontaktschicht S1 und der Zwischenschicht S2 war nahezu gleich mit 4 400 nm/h. Die Schichtwachstumsrate der Deckschicht S3 betrug ca. 300 nm/h.

Durch EDX-Messungen wurden Si Gehalte von unterhalb 2 at% in der Zwischenschicht S2 gemessen, die ansonsten aus den Elementen Al, Ti und N besteht. Es ist davon auszugehen, dass auch B und C in noch geringeren Mengen, wahrscheinlich unter 1 at%, mit geeigneten Messmethoden nachweisbar ist. Diese geringen Mengen an durch die Magnetronentladungsquellen Q2 eingebrachten Elemente sind Folge des Verhältnisses der Schichtwachstumsrate zwischen kathodischer Vakuum-Bogenverdampfung der Vakuum-Bogenverdampfungsquellen Q1 und der Magnetronentladungsquellen Q2 der HIPIMS-Magnetrons, das bei ca. 1:15 lag. Daneben könnte es sein, dass die Sputterrate in der Phase des Abscheidens der Zwischenschicht S2 zusätzlich niedriger ausfällt als in der Phase des Abscheidens der Deckschicht S3.

Eine REM Aufnahme eines Bruches der Schicht zeigt deutlich drei Bereiche:
1. eine mittels KVBV hergestellte kolumnare Kontaktschicht S1.
2. eine mittels KVBV//HIPIMS hergestellte Zwischenschicht S2 in Form einer Hybridschicht. Es wird ein feinkörniges Wachstum initiiert, wobei dieser Bereich wahrscheinlich auch eine extreme Nanolagigkeit aufweist, die jedoch nur mit extrem hochauflösenden Untersuchungen HRTEM nachweisbar ist, was bei den Untersuchungen nicht zur Verfügung stand.
3. eine mittels HIPIMS abgeschiedene amorphe Deckschicht.

Es sollte an dieser Stelle angemerkt werden, das der Übergang vom kolumnaren Wachstum der Kontaktschicht S1 zur feinkörnigen Zwischenschicht S2 durch den hybriden Betrieb der Vakuumbogenverdampfungsquelle Q1 und der Magnetronentladungsquelle Q2 entsteht. Der Einbau von Elementen wie Si, B,C führt dabei zu einer Kornverfeinerung bei AITIN-Schichten. Die Deckschicht S3 auf der Basis SiBNC wächst jedoch tendenziell mit einer amorphen Struktur auf.

Die Schichtelementzusammensetzung der Zwischenschicht S2 kann bei konstanten Materialien Verdampfungsmaterial M1 und Entladungsmaterial M2 und konstanter Vorspannung und konstanten sonstigen Prozessparametern durch das Verhältnis der Flüsse der schichtbildenden Teilchen der verschiedenen an den Flanschen der kathodischen VakuumBogenverdampfungsquellen Q1 und der Magnetronentladungsquellen Q2 angeflanschten Materialquellen variiert werden. Dies kann der Verdampferstrom der KVBV sein, die Leistung an den HIPIMS-Targets, oder aber auch einfach die Anzahl der verschiedenen aktiven Quellen in einer Ebene.

Betreibt man die Magnetronentladungsquellen M2 mit sehr hoher Leistung und / oder montiert man eine Vielzahl in einer Ebene, dann können die von diesen Quellen erzeugten Schichtelemente dominieren.

Hinzu kommt die Möglichkeit der Variation der Einzelschichtdicken bei von nanolagigen Systemen, die durch die Anordnung der kathodischen VakuumBogenverdampfungsquelle Q1 und der Magnetronentladungsquelle Q2 in der Kammer beeinflussbar ist.

Weiterhin ist zumindest das zeitlich wechselseitige Betreiben der Quellen des Types Q1 und des Types Q2 eine Methode, die integralen Anteile innerhalb der Gesamtschicht der Materialien M1 und M2 einzustellen.

Auch kann eine zeitliche Abfolge des Betreibens der Quellen Q1 und Q2 erfolgen, wenn mehrere Quellen Q1 und Q2 mit jeweils verschiednen Materialien vorhanden sind.

Dabei haben sich während der Versuchsdurchführungen verschiedene Verfahrensweisen als vorteilhaft erwiesen. Diese werden nachfolgend kurz beschrieben. Die bereits erwähnte Fig. 1b zeigt eine Prozesskammer 2 mit vier mit Quellen versehenen Flanschen, je zwei kathodische VakuumVerdampfungsquellen Q1 und zwei Magnetronentladungsquellen Q2, um eine gegenseitige Beschichtung zu vermeiden können die Positionen der Quellen Q1, Q2 mit Shuttern SC11, SC12, SC21, SC22 abgeschottet werden.

Bei einem ersten Verfahrensbeispiel zur Herstellung der Kontaktschicht S1 sind die Shutter SC11, SC12 vor mindestens einer kathodischen VakuumBogenverdampfungsquelle Q1 (KVBV) offen. Die Shutter SC21, SC22 vor den Magnetronentladungsquellen Q2 sind geschlossen um eine Beschichtung dieser Quelle zu vermeiden. In der Phase zur Abscheidung der Zwischenschicht S2 werden die Shutter SC21, SC22 vor den Magnetronentladungsquellen Q2 (HIPIMS) ebenfalls geöffnet. In der Phase zur Abscheidung Deckschicht S3 sind die Shutter SC11, SC12 vor den kathodischen Vakuum-Bogenverdampfungsquellen Q1 geschlossen und vor den Magnetronentladungsquellen Q2 offfen.

Bei einem zweiten Verfahrensbeispiel ist gemäss Fig. 1c eine Konfiguration gänzlich ohne Shutter gezeigt, d.h. es wird während der Phase der Abscheidung der Kontaktschicht S1 gemäss den Pfeilen PS durch die kathodischen Vakuum-Bogenverdampfungsquellen Q1 die Oberfläche der Magnetronentladungsquellen Q2 mit einigen 10 bis einigen 100 nm mit dem Schichtmaterial M1 der Kontaktschicht S1 beschichtet, wenn die Magnetronentladungsquelle Q2 nicht aktiv ist. Die trifft beispielsweise bei dem in den Ausführungsbeispielen 1 und 2 oben aufgeführte AITiN-Schichtsystemen zu. Diese auf die Magnetronentladungsquelle Q2 aufgetragene Schicht wird beim Start der Magnetronentladungsquelle Q2 (HIPIMS) zunächst abgetragen, so dass ein idealer Gradient der Schichteigenschaften (z.B. Struktur) bedingt durch das parallele Betreiben der beiden verschiedenen Beschichtungsquellen zwischen den Schichten S1 zu S2 erfolgt. Falls auf die Abscheidung der Schicht S2 verzichtet wird, ergibt sich ein idealer Übergang zwischen S1 und S3.

Bei einem dritten Verfahrensbeispiel gemäss Fig. 1d ist eine Konfiguration mit bewusst geöffneten Shuttern Sc21, SC22 vor der Magnetronentladungsquelle Q2 gezeigt, wenn die Kontaktschicht S1 abgeschieden wird. Die Form der Shutter SC21, SC22 und die Dauer der Shutteröffnung während der Schichtabscheidung der Kontaktschicht S1 bestimmt die Dicke der Abscheidung des Schichtmaterials, das von den kathodischen Vakuum-Bogenverdampfungsquellen Q1 erzeugt wird, damit ist also der Gradient der Schichteigenschaften (z.B. Struktur) bedingt durch das parallele Betreiben verschiedener Beschichtungsprozesse und der Schichtelemente einstellbar. Die ist beispielsweise der Fall bei den unten den oben beschriebenen Ausführungsbeispielen 1 und 2 aufgeführten AlTiN-Schichtsystemen. Falls auf die Abscheidung der Schicht S2 verzichtet wird, ergibt sich ein idealer Übergang zwischen S1 und S3.

In einem besonderen Fall kann gleich mit dem Hybridverfahren durch das Weglassen der Schicht S1 begonnen werden, so dass eine Schichtfolge S2/S3 entsteht. Diese kann dann mehrfach aufeinander gestapelt werden. Eine bevorzugte beschriebene Magnetkonfiguration für die HIPIMS-Sputterquellen ist wie bereits erwähnt ein unblanciertes Magnetron (UBM-Magnetfeld). Dies muss jedoch nicht notwendiger Weise zum Einsatz kommen, auch balancierte Magnetrons (BM Magnetfelder) können selbstverständlich eingesetzt werden. Weiterhin wurde eine closed field Konfiguration, insbesondere im Falle des bipolaren Betreibens zweier gegenüberliegender Magnetrons beschrieben. Es sind aber auch ohne Einschränkung Konfigurationen verwendbar, die nicht im closed field mode betrieben werden.

Weitere besondere Betriebsweisen in der Phase der Abscheidung der Zwischenschicht S2 und der Deckschicht S3 der HIPIMS- Magnetrons ist das zeitgleiche Starten identischer Pulser an den Magnetrons, das zeitgleiche Starten unterschiedlicher Pulse an den Magnetrons oder das zeitliche verschobene starten von identischen oder unterschiedlichen Pulsen.

Zur Betriebsweise der KVBV mit den Quellen Q1 sind alle üblichen Verfahren geeignet wie DC mit weitgehend konstanten Werten, gespulstes DC zwischen niedrigen Stromwerten und hohen Stromwerten, Hochstrompulsung.

Dabei ist unter HIPIMS-Betrieb von Magnetrons im Rahmen dieser Anmeldung zu verstehen, dass verschiedene Betriebsmoden anwendbar sind. In den Pulspausen können weitere Entladungen am Target betrieben werden, um die Plasmaentladung (z.B. positive Spannung am Target zur Entladung) zu steuern oder eine Vorionisation vor der Hochtrompulsung einzustellen. Die zusätzlichen Entladungen können auch dem Sputtern in den Pulspausen bei kleinen Entladungsleistungen dienen, um so beispielsweise Targetkontaminationen zu minimieren. Dieses zusätzliche Sputtern kann mittels DC-Entladungen, NF, MFund RF sein, bevorzugt wird dabei die Betriebsweise der Überlagerung von MF mit der eigentlichen Hochstrompulsung benutzt.

Die Bauformen der Quellen Q1 und Q2 können verschieden gewählt werden, so dass kreisförmige, zylinderförmige , rechteckige zu atomisierende Oberflächen (Targets, Kathoden) zur Verfügung stehen, weitere Formen sind dabei denkbar. Falls zylindrische Targets eingesetzt werden, können diese auch rotierend betrieben werden, um eine ideale Targetausnutzung zu gewährleisten.

Als Quellen Q1 können dabei auch gefilterte Bogenquellen zum Einsatz kommen. Es ist auch technisch realisierbar, die Quellen Q2 der HIPIMS Entladung mit Filtern zu versehen.

Beispielsweise lassen sich auch harte Kohlenstoffschichten darstellen, indem zunächst eine Cr/CrN Schicht S1 mit Q1 der KVBV abgeschieden wird. Dem folgt S2 als Betrieb von Q1 mittels Cr und Q2 mittels eines Graphittargets. Die Betriebsweise kann auch zeitliche Unterbrechungen aufweisen. Es entsteht eine S2 mit CrxCy-Anteilen. Auf diese wird dann mittels der Quelle Q2 eine harte Kohlenstoffschicht des Types a-C abgeschieden. Während dieser Phase ist auch eine Kombination mit einem PA-CVD-Prozess denkbar, der über ein kohlenwasserstoffhaltiges Gas Schichtanteile liefert, so dass a-C:H-Schichten entstehen.

Bei erfindungsgemässen Substraten hat die Kontaktschicht dabei bevorzugt eine Dicke von 0 - 50 000 nm, die Zwischenschicht (S2) bevorzugt eine Dicke von 50 nm - 10 000 nm und die Deckschicht (S3) bevorzugt eine Dicke von 10 nm - 10 000 nm.

## Patentansprüche

1. Beschichtungsverfahren zur Abscheidung eines Schichtsystems (S) gebildet aus Hartstoffschichten auf einem Substrat (1), umfassend die folgenden Verfahrensschritte:
- Bereitstellen einer evakuierbaren Prozesskammer (2) mit zwei kathodischen Vakuum-Bogenverdampfungsquellen (Q1) mit einem Verdampfungsmaterial (M1) installiert auf zwei gegenüberliegende Flanschen, und zwei Magnetronentladungsquellen (Q2) mit einem Entladungsmaterial (M2) installiert auf zwei gegenüberliegende Flanschen, um 90° gegenüber die VakuumBogenverdampfungsquellen (Q1) versetzt;
- Abscheiden mindestens einer Kontaktschicht (S1) umfassend das Verdampfungsmaterial (M1) auf der Oberfläche des Substrats (1) in einem kathodischen Vakuum-Bogenverdampfungsverfahren nur mittels die kathodischen Vakuum-Bogenverdampfungsquellen (Q1);
- nach dem Abscheiden der Kontaktschicht (S1), abscheiden mindestens eine Zwischenschicht (S2) in Form einer nanostrukturierten Mischschicht, insbesondere in Form einer nanolagigen Zwischenschicht (S2) in einer Hybridphase oder als Nanokompositschicht, umfassend das Verdampfungsmaterial (M1) und das Entladungsmaterial (M2), durch parallelen Betrieb der kathodischen VakuumBogenverdampfungsquellen (Q1) und der Magnetronentladungsquellen (Q2);
- und abschliessend, abscheiden mindestens eine Deckschicht (S3) umfassend das Material (M2) nur mittels die Magnetronentladungsquellen (Q2);
wobei während des Abscheidens der Zwischenschicht (S2) und während des Abscheidens der Deckschicht (S3) die Magnetronentladungsquellen (Q2) im bipolaren HIPIMS-Modus betrieben werden; und
wobei beim parallelen Betrieb der kathodischen Vakuum-Bogenverdampfungsquelle (Q1) und die Magnetronentladungsquellen (Q2) ein Beschichtungsdruck im Bereich von 0.5 Pa bis 20 Pa, bevorzugt im Bereich von 1 Pa bis 10 Pa gewählt wird.

2. Beschichtungsverfahren nach Anspruch 1, wobei beim reaktiven Abscheiden mittels des kathodischen Vakuum-Bogenverdampfungs-verfahrens die Kontaktschicht (S1) als nitridische Kontaktschicht (S1) und / oder die Zwischenschicht (S2) als nitridische Zwischenschicht (S2) ausgebildet wird.

3. Beschichtungsverfahren nach einem der Ansprüche 1 oder 2, wobei beim reaktiven Abscheiden mittels des kathodischen Vakuum-Bogenverdampfungsverfahrens die Kontaktschicht (S1) als karbidische Kontaktschicht (S1) und / oder die Zwischenschicht (S2) als karbidische Zwischenschicht (S2) ausgebildet wird.

4. Beschichtungsverfahren nach einem der vorangehenden Ansprüche, wobei beim reaktiven Abscheiden mittels des kathodischen Vakuum-Bogenverdampfungsverfahrens die Kontaktschicht (S1) als boridische Kontaktschicht (S1) und / oder die Zwischenschicht (S2) als boridische Zwischenschicht (S2) ausgebildet wird.

5. Beschichtungsverfahren nach einem der vorangehenden Ansprüche, wobei beim reaktiven Abscheiden mittels des kathodischen Vakuum-Bogenverdampfungsverfahrens die Kontaktschicht (S1) als oxidische Kontaktschicht (S1) und / oder die Zwischenschicht (S2) als oxidische Zwischenschicht (S2) ausgebildet wird.

6. Beschichtungsverfahren nach einem der vorangehenden Ansprüche, wobei beim reaktiven Abscheiden mittels des kathodischen Vakuum-Bogenverdampfungsverfahrens die Kontaktschicht (S1) und / oder die Zwischenschicht (S2) als Ti-Basisschicht, Zr-Basisschicht, WC-Basisschicht, oder als AlTi-Basisschicht, Cr-Basisschicht, TiSi-Basisischicht oder als AlCr-Basisischicht ausgebildet wird.

7. Beschichtungsverfahren nach einem der vorangehenden Ansprüche, wobei beim Beschichten mittels die Magnetronentladungsquellen (Q2) die Zwischenschicht (S2) und / oder die Deckschicht (S3) als VMe-Nitridschicht ausgebildet wird, wobei Me ein Metall ist.

8. Beschichtungsverfahren nach einem der vorangehenden Ansprüche, wobei beim Beschichten mittels die Magnetronentladungsquellen (Q2) die Zwischenschicht (S2) und / oder die Deckschicht (S3) als VZrN-Schicht mittels VZrN sputtern ausgebildet wird, wobei VZr insbesondere in der Zusammensetzung V=98.5at% und Zr=1.5at% in der Zwischenschicht (S2) und / oder die Deckschicht (S3) ausgebildet ist.

9. Beschichtungsverfahren nach einem der vorangehenden Ansprüche, wobei beim Beschichten mittels die Magnetronentladungsquellen (Q2) die Zwischenschicht (S2) und / oder die Deckschicht (S3) als MeSiBNCO-Schicht ausgebildet wird, wobei Me ein Metall ist.

10. Beschichtungsverfahren nach einem der vorangehenden Ansprüche, wobei beim Beschichten mittels die Magnetronentladungsquellen (Q2) die Zwischenschicht (S2) und / oder die Deckschicht (S3) als SiBNC-Schicht mittels SiBNC sputtern ausgebildet wird, wobei SiBC insbesondere in der Zusammensetzung Si=66at%, B=20 at% und C=14 at% in der Zwischenschicht (S2) und / oder die Deckschicht (S3) ausgebildet ist.

11. Beschichtungsverfahren nach einem der vorangehenden Ansprüche, wobei die Magnetronentladungsquellen (Q2) beim Sputtern im HIPIMS-Modus, insbesondere zur Abscheidung der Zwischenschicht (S2) und / oder zur Abscheidung der Deckschicht (S3), so eingestellt wird, dass in einer Pulsspitze mindest eine Stromdichte von 0.1 A/cm², vorzugsweise mindestens 0.3 A/cm² erreicht werden.

12. Beschichtungsverfahren nach einem der vorangehenden Ansprüche, wobei die Magnetronentladungsquellen (Q2) beim Sputtern im HIPIMS-Modus, insbesondere zur Abscheidung der Zwischenschicht (S2) und / oder zur Abscheidung der Deckschicht (S3), so eingestellt wird, dass Pulslängen zwischen 10 µs und 5000 µs und Pulspausen zwischen 100 µs und 10000 µs erreicht werden, wobei insbesondere ein Verhältnis von Pulslänge/Pulspause im Bereich von 1/3 bis 1/20 eingestellt wird.

13. Beschichtungsverfahren nach einem der vorangehenden Ansprüche, wobei die Magnetronentladungsquellen (Q2) durch die kathodische VakuumBogenverdampfungsquellen (Q1) mit Verdampfungsmaterial (M1) beschichtet wird.

## Claims

1. A coating method for depositing a layer system (S) formed from hard material layers on a substrate (1), including the following method steps:
- Providing an evacuable process chamber (2) having two cathodic vacuum arc evaporation sources (Q1) with an evaporation material (M1) installed on two opposite flanges, and having two magnetron discharge sources (Q2) with a discharge material (M2 installed on two opposite flanges, 90° offset from the vacuum arc evaporation sources (Q1);
- Depositing at least one contact layer (S1) including the evaporation material (M1) on the surface of the substrate (1) in a cathodic vacuum arc evaporation process only by means of the cathodic vacuum arc evaporation sources (Q1);
- after depositing the contact layer (S1), depositing at least one intermediate layer (S2) in the form of a nanostructured mixed layer, in particular in the form of a nano-layered intermediate layer (S2) in a hybrid phase or as a nanocomposite layer, comprising the evaporation material (M1) and the discharge material (M2), by parallel operation of the cathodic vacuum arc evaporation sources (Q1) and of the magnetron discharge sources (Q2);
- and finally, depositing at least one top layer (S3) comprising the material (M2) only by means of the magnetron discharge sources (Q2);
wherein during deposition of the interlayer (S2) and during deposition of the overlayer (S3), the magnetron discharge sources (Q2) are operated in a bipolar HIPIMS mode; and
wherein during parallel operation of the cathodic vacuum arc evaporation sources (Q1) and the magnetron discharge sources (Q2) a coating pressure in the range of 0.5 Pa to 20 Pa, preferably in the range of 1 Pa to 10 Pa, is selected.

2. A coating method in accordance with claim 1, wherein in the reactive depositing by means of the cathodic vacuum arc evaporation method the contact layer (S1) is formed as a nitride contact layer (S1) and/or the intermediate layer (S2) is formed as a nitride intermediate layer (S2).

3. A coating method in accordance with one of the claims 1 or 2, wherein in the reactive depositing by means of the cathodic vacuum arc evaporation method the contact layer (S1) is formed as a carbide contact layer (S1) and/or the intermediate layer (S2) is formed as a carbide intermediate layer (S2).

4. A coating method in accordance with any of the preceding claims, wherein in the reactive depositing by means of the cathodic vacuum arc evaporation method the contact layer (S1) is formed as a boride contact layer (S1) and/or the intermediate layer (S2) is formed as a boride intermediate layer (S2).

5. A coating method in accordance with any of the preceding claims, wherein in the reactive depositing by means of the cathodic vacuum arc evaporation method the contact layer (S1) is formed as an oxide contact layer (S1) and/or the intermediate layer (S2) is formed as an oxide intermediate layer (S2).

6. A coating method in accordance with any of the preceding claims, wherein in the reactive depositing by means of the cathodic vacuum arc evaporation method the contact layer (S1) and/or the intermediate layer (S2) is formed as a Ti base layer, a Zr base layer, a WC base layer or as an AITi base layer, a Cr base layer, a TiSi base layer or as an AlCr base layer.

7. A coating method in accordance with any of the preceding claims, wherein on the coating by means of the magnetron discharge sources (Q2) the intermediate layer (S2) and/or the top layer (S3) is formed as a VMe nitride layer, where Me is a metal.

8. A coating method in accordance with any of the preceding claims, wherein on the coating by means of the magnetron discharge sources (Q2) the intermediate layer (S2) and/or the top layer (S3) is formed as a VZrN layer by means of VZrN sputtering, with VZr in particular being formed in the composition V = 98.5 at% and Zr = 1.5 at% in the intermediate layer (S2) and/or the top layer (S3).

9. A coating method in accordance with any of the preceding claims, wherein on the coating by means of the magnetron discharge sources (Q2) the intermediate layer (S2) and/or the top layer (S3) is formed as an MeSiBNCO layer, where Me is a metal.

10. A coating method in accordance with any of the preceding claims, wherein on the coating by means of the magnetron discharge source (Q2) the intermediate layer (S2) and/or the top layer (S3) is formed as an SiBNC layer by means of SiBNC sputtering, with SiBC in particular being formed in the composition Si = 66 at%, B = 20 at% and C = 14 at% in the intermediate layer (S2) and/or the top layer (S3).

11. A coating method in accordance with any of the preceding claims, wherein the magnetron discharge sources (Q2) is set during the sputtering in the high ionized impulse magnetron sputtering mode, in particular for depositing the intermediate layer (S2) and/or for depositing the top layer (S3), such that in a pulse peak at least one current density of 0.1 A/cm2, preferably 0.3 A/cm2, is reached.

12. A coating method in accordance with any of the preceding claims, wherein the magnetron discharge sources (Q2) is set during the sputtering in the high ionized impulse magnetron sputtering mode, in particular for depositing the intermediate layer (S2) and/or for depositing the top layer (S3) such that pulse lengths between 10 µs and 5000 µs and pulse breaks between 100 µs and 10,000 µs are reached, whereby in particular a ratio of pulse length/pulse pause is set in the range from 1/3 to 1/20 .

13. A coating method according to any of the preceding claims, wherein the magnetron discharge sources (Q2) are coated with evaporation material (M1) by the cathodic vacuum arc evaporation sources (Q1).

## Revendications

1. Un procédé de revêtement pour déposer un système de couches (S) formé de couches de matériau dur sur un substrat (1), comprenant les étapes de procédé suivantes :
- Fournir une chambre de traitement (2) évacuable avec deux sources d'évaporation cathodique à arc sous vide (Q1) avec un matériau d'évaporation (M1) installé sur deux brides opposées, et deux sources de décharge magnétron (Q2) avec un matériau de décharge (M2) installé sur deux brides opposées, décalées de 90° par rapport aux sources d'évaporation à arc sous vide (Q1) ;
- Déposer au moins une couche de contact (S1) comprenant le matériau d'évaporation (M1) sur la surface du substrat (1) dans un procédé d'évaporation cathodique à arc sous vide uniquement au moyen des sources d'évaporation cathodique à arc sous vide (Q1) ;
- après le dépôt de la couche de contact (S1), déposer au moins une couche intermédiaire (S2) sous la forme d'une couche mixte nanostructurée, en particulier sous la forme d'une couche intermédiaire nanométrique (S2) dans une phase hybride ou comme une couche nano-composite, comprenant le matériau d'évaporation (M1) et le matériau de décharge (M2), par un fonctionnement en parallèle des sources d'évaporation cathodique à arc sous vide (Q1) et des sources de décharge magnétron (Q2) ;
- et enfin, déposer au moins une couche couvrante (S3) comprenant le matériau (M2) uniquement au moyen des sources de décharge magnétron (Q2) ;
dans lequel, pendant le dépôt de la couche intermédiaire (S2) et pendant le dépôt de la couche couvrante (S3), les sources de décharge magnétron (Q2) fonctionnent en mode bipolaire HIPIMS ; et
dans lequel pendant le fonctionnement en parallèle de la source d'évaporation cathodique à arc sous vide (Q1) et des sources de décharge magnétron (Q2), une pression de revêtement est sélectionnée dans la plage de 0,5 Pa à 20 Pa, de préférence dans la plage de 1 Pa à 10 Pa.

2. Un procédé de revêtement selon la revendication 1, dans lequel, lors du dépôt réactif au moyen du procédé d'évaporation cathodique à arc sous vide, la couche de contact (S1) est formée comme couche de contact (S1) nitridique et/ou la couche intermédiaire (S2) est formée comme couche intermédiaire (S2) nitridique.

3. Un procédé de revêtement selon l'une des revendications 1 ou 2, dans lequel, lors du dépôt réactif au moyen du procédé d'évaporation cathodique à arc sous vide, la couche de contact (S1) est formée comme couche de contact (S1) en carbure et/ou la couche intermédiaire (S2) est formée comme couche intermédiaire (S2) en carbure.

4. Un procédé de revêtement selon l'une des revendications précédentes, dans lequel, lors du dépôt réactif au moyen du procédé d'évaporation cathodique à arc sous vide, la couche de contact (S1) est formée comme couche de contact (S1) de borure et/ou la couche intermédiaire (S2) est formée comme couche intermédiaire (S2) de borure.

5. Un procédé de revêtement selon l'une des revendications précédentes, dans lequel, lors du dépôt réactif au moyen du procédé d'évaporation cathodique à arc sous vide, la couche de contact (S1) est formée comme couche de contact (S1) d'oxyde et/ou la couche intermédiaire (S2) est formée comme couche intermédiaire (S2) d'oxyde.

6. Un procédé de revêtement selon l'une des revendications précédentes, dans lequel, lors du dépôt réactif au moyen du procédé d'évaporation cathodique à arc sous vide, la couche de contact (S1) et/ou la couche intermédiaire (S2) est formée comme une couche de base de Ti, une couche de base de Zr, une couche de base de WC, ou comme une couche de base de AlTi, une couche de base de Cr, une couche de base de TiSi ou comme une couche de base de AlCr.

7. Un procédé de revêtement selon l'une des revendications précédentes, dans lequel, lors du revêtement au moyen des sources de décharge magnétron (Q2), la couche intermédiaire (S2) et/ou la couche couvrante (S3) est formée comme une couche de nitrure VMe, dans lequel Me est un métal.

8. Un procédé de revêtement selon l'une des revendications précédentes, dans lequel, lors du revêtement au moyen des sources de décharge magnétron (Q2), la couche intermédiaire (S2) et/ou la couche couvrante (S3) est formée comme une couche de VZrN au moyen d'une pulvérisation catodique de VZrN, dans lequel VZr est formé en particulier dans la composition V=98,5 at% et Zr=1,5 at% dans la couche intermédiaire (S2) et/ou la couche couvrante (S3).

9. Un procédé de revêtement selon l'une des revendications précédentes, dans lequel, lors du revêtement au moyen des sources de décharge magnétron (Q2), la couche intermédiaire (S2) et/ou la couche couvrante (S3) est formée comme une couche de MeSiBNCO, dans lequel Me est un métal.

10. Un procédé de revêtement selon l'une des revendications précédentes, dans lequel, lors du revêtement au moyen des sources de décharge magnétron (Q2), la couche intermédiaire (S2) et/ou la couche couvrante (S3) est formée comme une couche de SiBNC au moyen d'une pulvérisation cathodique de SiBNC, dans lequel SiBC est formé en particulier dans la composition Si=66 at%, B=20 at% et C=14 at% dans la couche intermédiaire (S2) et/ou la couche couvrante (S3).

11. Un procédé de revêtement selon l'une des revendications précédentes, dans lequel les sources de décharge magnétron (Q2) sont réglées pendant la pulvérisation cathodique en mode HIPIMS, en particulier pour le dépôt de la couche intermédiaire (S2) et/ou pour le dépôt de la couche couvrante (S3), de telle sorte que dans une crête d'impulsion, une densité de courant d'au moins 0,1 A/cm², de préférence d'au moins 0,3 A/cm² est obtenue.

12. Un procédé de revêtement selon l'une des revendications précédentes, dans lequel les sources de décharge magnétron (Q2) sont réglées pendant la pulvérisation cathodique en mode HIPIMS, en particulier pour le dépôt de la couche intermédiaire (S2) et/ou pour le dépôt de la couche couvrante (S3), de telle sorte que des longueurs d'impulsion comprises entre 10 µs et 5000 µs et des pauses d'impulsion comprises entre 100 µs et 10000 µs sont obtenues, dans lequel en particulier un rapport de longueur d'impulsion/pause d'impulsion est réglé dans la plage de 1/3 à 1/20.

13. Un procédé de revêtement selon l'une des revendications précédentes, dans lequel les sources de décharge magnétron (Q2) sont revêtues de matériau d'évaporation (M1) par les sources d'évaporation cathodique à arc sous vide (Q1).
